(19) Europäisches Patentamt
European Patent Office
Office européen des brevets

(11) Publication number: **0 090 817**
**B1**

(12) **EUROPEAN PATENT SPECIFICATION**

(45) Date of publication of patent specification: **08.01.86**

(51) Int. Cl.$^4$: **C 30 B 1/10**, C 30 B 23/02, C 30 B 25/02, C 30 B 29/40, C 23 C 14/06

(21) Application number: **82902907.3**

(22) Date of filing: **04.10.82**

(86) International application number: **PCT/GB82/00283**

(87) International publication number: **WO 83/01466 28.04.83 Gazette 83/10**

# (54) THIN FILMS OF COMPOUNDS AND ALLOY COMPOUNDS OF GROUP III AND GROUP V ELEMENTS.

(30) Priority: **15.10.81 GB 8131180**

(43) Date of publication of application: **12.10.83 Bulletin 83/41**

(45) Publication of the grant of the patent: **08.01.86 Bulletin 86/02**

(84) Designated Contracting States: **AT BE CH DE FR GB LI LU NL SE**

(56) References cited:
**DE-B-1 057 845**
**FR-A-2 292 517**

(73) Proprietor: **PRUTEC LIMITED**
**142 Holborn Bars**
**London EC1N 2NH (GB)**

(72) Inventor: **DAVEY, Keith, Simon**
**7, St.Mary's Walk Fowlmere**
**Royston, Herts (GB)**

(74) Representative: **Messulam, Alec Moses**
**A. Messulam & Co. 24 Broadway**
**Leigh on Sea Essex SS9 1BN (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 090 817 B1

**Description**

This invention relates to thin films of compounds (which term is intended to include alloy compounds) of elements drawn from Group III and Group V of the periodic table, and is concerned particularly, but not exclusively, with the production of thin films of semiconductor compounds such as gallium arsenide or gallium arsenide compounds, for example for use in terrestial solar cells.

In bulk form gallium arsenide or gallium arsenide compounds, can be used as the active semiconductor in solar cells with high conversion efficiency. Gallium arsenide is expensive, thus in order to reduce cell cost it is desirable to produce cells which use only very thin films of gallium arsenide while nevertheless retaining high conversion efficiency. Accordingly, there has sought a method of producing photovoltaic cells with thin films of gallium arsenide using a manufacturing process which enables low cost mass production of large areas of cells.

Various methods are known for producing thin films of semiconductor compounds such as gallium arsenide, one such method is disclosed in DE—B—1 057 845. These known methods have used either chemical vapour deposition (CVD) processes or liquid phase epitaxy (LPE) techniques to produce the films.

The CVD processes are similar to those used for the manufacture of expensive small area optoelectronic components such as laser emitters. The CVD processes use at least two gaseous species separately containing say, gallium and arsenic-carrying molecules which react together when passed over a heated substrate to produce a thin film of gallium arsenide. The substrates are small and heated to a high temperature. Typically the reactant species are gaseous trimethylgallium and arsine gas, or gaseous gallium chloride and arsine gas.

The gaseous reactants used in such known methods are difficult to contain, meter and control in the reaction area. In addition, the particular reactions employed require high substrate temperatures to produce thin film gallium arsenide solar cells with suitable performance characteristics. These problems have resulted in the CVD manufacturing process requiring expensive and complex equipment which produces solar cells of relatively small area.

LPE techniques involve depositing by precipitation the solid semiconductor compound from a saturated solution in a metal. Saturation is achieved by dissolving solid compound in the metal, and then cooling the solution. These techniques, like CVD techniques, have been developed for the production of small area optoelectronic and similar devices. Using LPE techniques, it is expensive to produce an area larger than a few square centimetres, and furthermore the process is difficult to control and slow in production.

It is accordingly an object of the present invention to provide a method of producing thin films of compounds, including alloy compounds, of Group III and Group V elements suitable for low cost production of large areas.

According to one aspect of the present invention, there is provided a method of producing a thin film of a compound of Group III and Group V elements, characterised by the steps of forming a liquid film of the Group III element on a suitable substrate (1), the film having a thickness in the range from 0.5 to 50 μm, and exposing the liquid film to a gaseous atmosphere comprising the Group V element in gaseous form, at an appropriate temperature, until the Group III element in the liquid film has reacted with the gaseous atmosphere to produce the desired compound.

When practising the method of the invention, the Group V element in gaseous form reacts with the thin film of the Group III element to produce a thin film of the desired compound or alloy compound. A typical reaction, in the case where the Group III element is gallium and the Group V element is arsenic in the form of arsine, would be as follows:

$$2\ Ga + 2\ AsH_3 \rightarrow 2\ GaAs + 3\ H_2$$

The invention may be used for producing various types of thin film suitable for various different applications, including for example, the production of thin films of GaAs, GaP or their compounds for use in large area light-emitting diodes. Use of the invention for this purpose enables the production of large area displays at low cost.

The invention also finds particular application in the production of thin films of gallium arsenide or gallium arsenide compounds, e.g. for use in solar cells.

Hence, in a preferred aspect, the present invention provides a method of producing a thin film selected from the group comprising gallium arsenide, gallium phosphide, a gallium arsenide compound and a gallium phosphide compound, comprising forming a thin film of gallium on a suitable substrate, and exposing the thin film to a gaseous atmosphere comprising at least one of arsenic and phosphorus in gaseous form, at an appropriate temperature to result in production of a thin film of the desired composition.

If desired the characteristics of the resulting film can be controlled, e.g. to produce a film having suitable properties for good solar cell operation, by introducing suitable dopant impurities. This can be effected either by incorporating a suitable dopant into the thin film of the Group III element via the Group III element, or by adding a suitable gas, such as hydrogen sulphide, to the gaseous atmosphere.

A suitable substrate is selected depending upon the intended use of the thin film. For example, in the case of a thin film for use in a solar cell, the substrate is preferably conductive on at least on one surface thereof. The substrate may either be of conductive material, or may comprise an insulator with a conductive, e.g. metallic, coating.

Suitable substrates for this purpose include tungsten coated graphite and gold covered glass. The substrate is conveniently flexible to facilitate treatment.

The thin film of the Group III element, e.g. gallium, has a thickness in the range 0.5 to 50 µm.

The thin film may be formed on the substrate by any suitable technique, such as evaporation, sputtering, dip coating, spreading or electroplating.

The gaseous atmosphere conveniently comprises the selected Group V element in gaseous form (e.g. arsenic in the form of arsine, or phosphorous in the form of phosphine) and an inert gas, such as nitrogen or helium.

Suitable reaction conditions depend on the reactants. For instance, in cases where the Group III element is gallium, a suitable temperature at which the thin film and gaseous atmosphere will react is in the range 150°C to 750°C. Suitable operating conditions are conveniently achieved by heating the substrate coated with the thin film to an appropriate temperature and passing the gaseous atmosphere over the heated substrate until all of the Group III element has reacted to produce the desired compound.

The method is preferably conducted in a continuous manner. This is conveniently achieved by producing a suitable thin film coating on the substrate, e.g. by dipping or continuous electroplating, and then passing the coated substrate through a gas seal into a gaseous reaction chamber through which the substrate is passed and through which is also passed the gaseous atmosphere. The substrate is conveniently heated in the reaction chamber, e.g. by means of a suitable heater located in the chamber.

The apparatus for producing a thin film of a compound, including an alloy compound, of Group III and Group V elements, includes means for forming a thin layer of a selected Group III element on a suitable substrate, and a gaseous reaction chamber wherein the substrate and thin film are exposed to a gaseous atmosphere comprising a selected Group V element in gaseous form.

The means for forming a thin layer of the element on the substrate may comprise for example, a dip tank for dip coating the substrate, an evaporation chamber, sputtering means, spreading means, or electroplating means.

The apparatus conveniently includes feed means, e.g. drive rollers, for causing continuous feeding of the substrate through the apparatus.

The gaseous reaction chamber conveniently comprises a generally closed chamber with a gap inlet and outlet and also a substrate inlet and outlet for permitting the substrate to be passed into and out of the chamber in a manner which does not permit significant escape of the gaseous atmosphere from the chamber.

A substrate heater is conveniently located in the gaseous reaction chamber.

The present invention also includes within its scope a thin film produced by the method of the invention.

The invention will be further described by way of example, with reference to the accompanying drawing, the single Figure of which is a schematic view illustrating one embodiment of apparatus in accordance with the invention.

In the Figure, a substrate 1 in the form of a flexible band of material, typically 20 cm wide and 0.2 cm thick, made from graphite film coated with tungsten is shown being passed continuously through reaction apparatus under the action of drive rollers 4.

The substrate 1 is first passed through a dip tank 3 where it is passed by the action of guide roller 5 through a bath containing gallium metal 2 at a temperature above its melting point of 30°C. This serves to produce a thin film of gallium on the substrate.

The substrate is then passed through a reaction chamber 8. The substrate enters via inlet 6, which includes sealing means for preventing any significant escape of gas from the chamber. The chamber 8 also includes inlets 7 for introducing gases, including inert gas, arsine and dopant gas to the chamber.

In the chamber, the substrate is moved past a substrate heater 9 which heats the substrate to a temperature typically in the range 150°C to 750°C. The heated substrate reacts with the gaseous atmosphere in the chamber to produce a thin film of gallium arsenide.

The substrate with this film exits the chamber 8 via outlet 11 which includes sealing means and is of similar construction to inlet 6. The chamber also includes a gas outlet 10.

**Claims**

1. A method of producing a thin film of a compound of Group III and Group V elements, characterised by the steps of forming a liquid film of the Group III element on a suitable substrate (1), the film having a thickness in the range from 0.5 to 50 µm, and exposing the liquid film to a gaseous atmosphere comprising the Group V element in gaseous form, at an appropriate temperature, until the Group III element in the liquid film has reacted with the gaseous atmosphere to produce the desired compound.

2. A method as claimed in claim 1, wherein the substrate (1) is in the form of a continuous sheet which is fed progessively past a first station (2, 3) at which the liquid film of the Group III element is applied and which is subsequently passed through a gas seal into a gaseous reaction chamber (8) into which the gaseous atmosphere is introduced.

3. A method as claimed in claim 2, wherein the substrate (1) is conductive on at least one surface thereof.

4. A method as claimed in claim 3, wherein the substrate (1) is formed of conductive material or an insulating material coated with an electrically conductive layer.

5. A method as claimed in claim 4, wherein the

substrate is formed of graphite coated with tungsten.

6. A method as claimed in any one of claims 3 to 5, wherein the substrate (1) is flexible.

7. A method as claimed in any one of the preceding claims, wherein the liquid film is formed by dip coating.

8. A method as claimed in any one of the preceding claims, wherein the gaseous atmosphere comprises arsenic in the form of arsine or phosphorous in the form of phosphine and an inert gas.

9. A method as claimed in claim 8, wherein the Group III element is gallium and the liquid film of gallium and the gaseous atmosphere are made to react with one another at a temperature in the range from 150°C to 750°C.

10. A method as claimed in claim 9, which comprises heating the substrate coated with the liquid film to an appropriate temperature and passing the gaseous atmosphere over the heated substrate until all of the Group III element has reacted to produce the desired compound.

11. A method as claimed in claim 10, wherein the substrate is heated in the reaction chamber containing the gaseous atmosphere by means of a heater (9) located in the chamber (8).

12. A method as claimed in any one of the preceding claims, wherein dopant impurities are included in the thin film to control the properties of the film.

13. A method as claimed in claim 12, wherein the dopant is added to the Group III element.

14. A method as claimed in claim 12, wherein the dopant is added to the gaseous atmosphere containing the Group V element.

15. A method as claimed in claim 14, wherein the dopant is introduced in the form of hydrogen sulphide gas into the gaseous atmosphere.

**Revendications**

1. Procédé de production d'un film fin d'un composé d'éléments du Groupe III et du Groupe V, caractérisé par l'étape de formation d'un film liquide de l'élément du Groupe III sur un substrat (1) convenable, le film étant d'une épaisseur dans l'intervalle de 0,5 à 50 µm, et par l'étape d'exposition du film liquide à une atmosphère gazeuse comportant l'élément du Groupe V sous forme gazeuse, à une température appropriée, jusqu'à ce que l'élément du Groupe III dans le film liquide ait réagi avec l'atmosphère gazeuse pour donner le composé désiré.

2. Procédé selon la revendication 1, caractérisé en ce que le substrat (1) est sous la forme d'une feuille continue, qui est avancée progressivement le long d'un premier poste (2, 3) auquel on applique le film liquide de l'élément du Groupe III, feuille que l'on fait ensuite passer, à travers un sas à gaz, dans une enceinte à réaction gazeuse (8), dans laquelle on introduit l'atmosphère gazeuse.

3. Procédé selon la revendication 2, caractérisé en ce que le substrat (1) est conducteur sur au moins l'une de ses surfaces.

4. Procédé selon la revendication 3, caractérisé en ce que le substrat (1) est constitué de matériau conducteur ou d'un matériau isolant revêtu d'une couche conductrice de l'électricité.

5. Procédé selon la revendication 4, caractérisé en ce que le substrat est constitué de graphite revêtu de tungstène.

6. Procédé selon l'une quelconque des revendications 3 à 5, caractérisé en ce que le substrat (1) est souple.

7. Procédé selon l'une quelconque des revendications précédentes, caractérisé en ce que le film liquide est produit par revêtement au trempé.

8. Procédé selon l'une quelconque des revendications précédentes, caractérisé en ce que l'atmosphère gazeuse comporte de l'arsenic sous forme d'arsine, ou du phosphore sous forme de phosphine, et un gaz inerte.

9. Procédé selon la revendication 8, caractérisé en ce que l'élément du Groupe III est le gallium, et en ce que l'on fait réagir l'un avec l'autre le film liquide de gallium et l'atmosphère gazeuse, à une température dans l'intervalle de 150°C à 750°C.

10. Procédé selon la revendication 9, caractérisé en ce qu'il comprend le chauffage du substrat revêtu du film liquide jusqu'à une température appropriée, et le passage de l'atmosphère gazeuse sur le substrat chauffé jusqu'à ce que tout l'élément du Groupe III ait réagi pour donner le composé désiré.

11. Procédé selon la revendication 10, caractérisé en ce que l'on chauffe le substrat, dans l'enceinte réactionnelle contenant l'atmosphère gazeuse, au moyen d'un élément chauffant (9) situé dans l'enceinte (8).

12. Procédé selon l'une quelconque des revendications précédentes, caractérisé en ce que l'on inclut des impuretés dopantes dans le film fin, pour réguler les propriétés du film.

13. Procédé selon la revendication 12, caractérisé en ce que l'on ajoute le dopant à l'élément du Groupe III.

14. Procédé selon la revendication 12, caractérisé en ce que l'on ajoute le dopant à l'atmosphère gazeuse contenant l'élément du Groupe V.

15. Procédé selon la revendication 14, caractérisé en ce que l'on introduit le dopant dans l'atmosphère gazeuse, sous forme de gaz hydrogène sulfureux.

**Patentansprüche**

1. Verfahren zur Herstellung eines dünnen Films einer Verbindung von Elementen der Gruppen III und V, dadurch gekennzeichnet, dass man stufenweise einen flüssigen Film des Elements aus Gruppe III auf einem geeigneten Substrat (1) bildet, wobei der Film eine Dicke im Bereich von 0,5 bis 50 µm aufweist, und den flüssigen Film bei geeigneter Temperatur einer Gasatmosphäre aussetzt, die das Element aus Gruppe V gasförmig enthält, bis sich das Element aus Gruppe III im flüssigen Film mit der Gasatmosphäre zu der erwünschten Verbindung umgesetzt hat.

2. Verfahren nach Anspruch 1, worin das Substrat (1) als endlose Bahn vorliegt, die an einer ersten Station (2, 3) fortlaufend vorbeigeführt wird, wo der flüssige Film des Elements aus Gruppe III aufgebracht wird, und die danach durch eine Gasabdichtung in eine Gasreaktionskammer (8), in welche die Gasatmosphäre eingeleitet wird, überführt wird.

3. Verfahren nach Anspruch 2, worin das Substrat (1) mindestens auf einer seiner Oberflächen leitend ist.

4. Verfahren nach Anspruch 3, worin das Substrat (1) aus einem leitenden Material oder einem isolierenden Material, das mit einer elektrisch leitenden Schicht beschichtet ist, besteht.

5. Verfahren nach Anspruch 4, worin das Substrat aus mit Wolfram beschichtetem Graphit gebildet ist.

6. Verfahren nach einem der Ansprüche 3 bis 5, worin das Substrat (1) biegsam ist.

7. Verfahren nach einem der vorhergehenden Ansprüche, worin der flüssige Film durch Tauchbeschichtung gebildet wird.

8. Verfahren nach einem der vorhergehenden Ansprüche, worin die Gasatmosphäre Arsen in Form von Arsin oder Phosphor in Form von Phosphin und ein inertes Gas enthält.

9. Verfahren nach Anspruch 8, worin als Element aus Gruppe III Gallium vorliegt und der flüssige Galliumfilm sowie die Gasatmosphäre bei einer Temperatur im Bereich von 150°C bis 750°C miteinander zur Reaktion gebracht werden.

10. Verfahren nach Anspruch 9, darin bestehend, dass man das mit dem flüssigen Film beschichtete Substrat auf eine geeignete Temperatur erhitzt und die Gasatmosphäre über das erhitzte Substrat leitet, bis sich das Element aus Gruppe III vollständig zu der erwünschten Verbindung umgesetzt hat.

11. Verfahren nach Anspruch 10, worin das Substrat in der die Gasatmosphäre enthaltenden Reaktionskammer mittels eines in der Kammer (8) angeordneten Heizkörpers (9) erhitzt wird.

12. Verfahren nach einem der vorhergehenden Ansprüche, worin der dünne Film ferner dotierende Verunreinigungen zur Regulierung der Eigenschaften des Films enthält.

13. Verfahren nach Anspruch 12, worin das Dotiermittel dem Element aus Gruppe III zugesetzt wird.

14. Verfahren nach Anspruch 12, worin das Dotiermitter der das Element aus Gruppe V enthaltenden Gasatmosphäre zugesetzt wird.

15. Verfahren nach Anspruch 14, worin das Dotiermittel in Form von Schwefelwasserstoffgas in die Gasatmosphäre eingeführt wird.

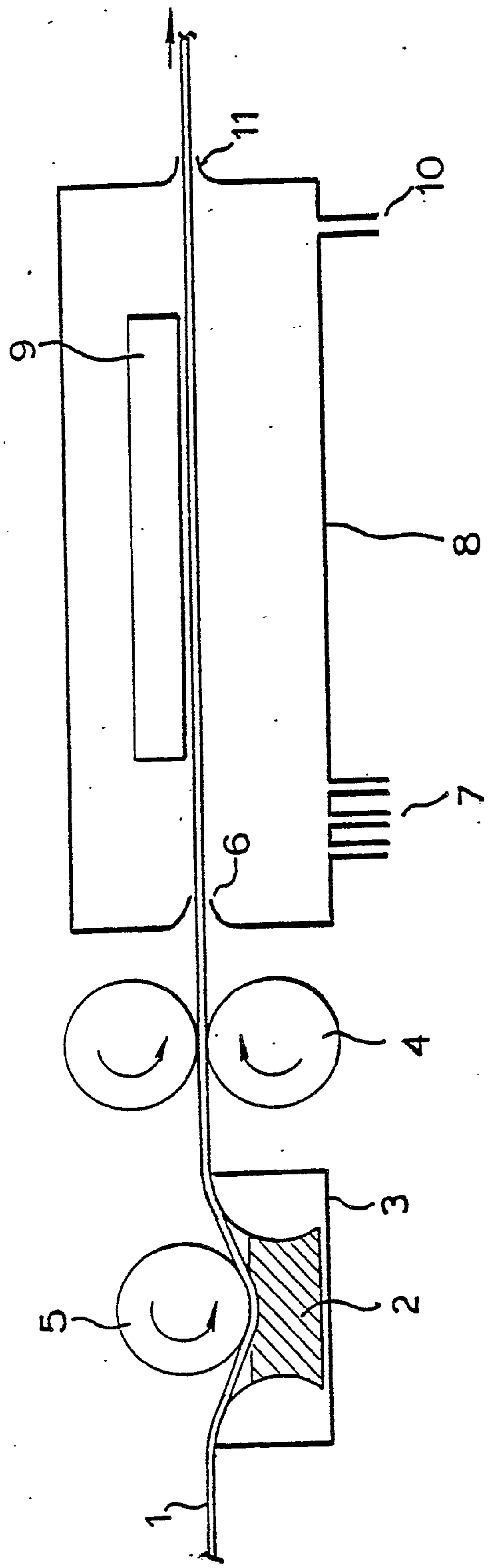
11
10
9
8
7
6
4
3
2
5
1